# EUROPEAN PATENT APPLICATION

(11) **EP 4 528 828 A1**
(43) Date of publication of application: **26.03.2025**
(21) Application number: 23199418.7
(22) Date of filing: 25.09.2023
(51) Int. Cl.: H01L 31/048, H01L 31/049, H01L 31/054

(54) **SOLAR MODULE WITH ENHANCED SOLAR CELL PERFORMANCE**

(71) Applicant: MEGA P&C Advanced Materials (Shanghai) Company Limited, Shanghai (CN)
(72) Inventor: Draaisma, Guy, 6132 TJ Sittard (NL); Reardon, Damien, 5658AT Eindhoven (NL)
(74) Representative: Cabinet Chaillot

(57) **Abstract**

The invention relates to a solar module comprising
(a) a glass front sheet at the top of the solar module,
(b) a first encapsulant adhesive layer, preferably having a refractive index in the range of from 1.40 to 1.60,
(c) a solar cell layer, comprising a bifacial solar cell and having optionally multiple layers, having a refractive index in the range of from 1.80 to 5.00,
(d) a second encapsulant adhesive layer, preferably having a refractive index in the range of from 1.40 to 1.60,
(e) a backsheet at the bottom of the solar module,
wherein between the solar cell layer (c) and the second encapsulant adhesive layer (d) an additional layer R with a refractive index in the range of from 1.15 to 1.50 and a thickness of 250 to 10000 nm is present.

## Description

The invention relates to a solar module comprising a glass front sheet at the top of the solar module, a solar cell layer with a first encapsulant adhesive layer on the upper side of the solar cell layer and a second encapsulant adhesive layer on the lower side of the solar cell layer, a backsheet at the bottom of the solar module, wherein between the solar cell layer and the backsheet an additional layer is present which has a lower refractive index than the solar cell layer as well as a process for producing said solar modules.

Solar panels are a sustainable option to produce energy from free, naturally abundant solar irradiation. In general, solar panels comprise four components which are 1) a protective glass front sheet to protect the solar cells from degradation by the environment, 2) the solar cell which usually comprises semiconductor photoelectric materials to convert the solar irradiation to a current and which is covered by 3) an encapsulant as well as 4) an insulating backsheet which protects the solar cells from the environment. It also electrically insulates the solar module from short circuits and electrical shock.

In US 2020/0313018 A1 the preparation of a solar cell is disclosed wherein the backsheet comprises a polyester film and a printing layer containing a white pigment to improve power conversion efficiency of the solar cell. However, solar modules used in the private sectors do not have backsheets containing white pigments due to aesthetic reasons and bias from private customers. Further, it is still necessary to improve the efficiency of solar modules in general.

It is therefore the object of the present invention to provide a solar module with an improved performance, especially for solar modules comprising black backsheets.

Accordingly, the present invention provides a solar module comprising
(a) a glass front sheet at the top of the solar module,
(b) a first encapsulant adhesive layer, preferably having a refractive index in the range of from 1.40 to 1.60,
(c) a solar cell layer, comprising a bifacial solar cell and having optionally multiple layers, having a refractive index in the range of from 1.80 to 5.00,
(d) a second encapsulant adhesive layer, preferably having a refractive index in the range of from 1.40 to 1.60,
(e) a backsheet at the bottom of the solar module, preferably comprising black pigments,
wherein between the solar cell layer (c) and the second encapsulant adhesive layer (d) an additional layer R with a refractive index in the range of from 1.15 to 1.50 and a thickness in the range of from 250 nm to 10000 nm, preferably comprising silica nanoparticles, is present. The refractive indices given in the application refer to the refractive index in the wavelength range of from 350 nm to 1200 nm.

The glass front sheet (a) at the top of the solar module gives mechanical stability to the module and protects the solar cells from environmental degradation. The glass front sheet is preferably made of tempered glass. Optionally, the glass front sheet is coated with an anti-reflective coating and/or anti-soiling coating to reduce the reflection of sun light and increase the transmittance of the solar spectrum to the solar cell.

Between the glass front sheet (a) and the solar cell layer (c) a first encapsulant adhesive layer (b) is present to further protect the solar cell against, corrosion or mechanical stress. The encapsulant preferably comprises ethylene-vinyl acetate. The thickness of the first encapsulant adhesive layer (b) can be up to 3 mm, preferably in the range of from 20 to 200 µm. The first encapsulant adhesive layer (b) has preferably a refractive index in the range of from 1.40 to 1.60, more preferably 1.45 to 1.55, most preferably 1.47 to 1.55.

The solar cell layer (c) comprises bifacial solar cells, which means that the conversion of light is performed on the upper side directed to the glass front sheet (a) and on the lower side directed to the backsheet (e). The solar cells can be made of monocrystalline, polycrystalline or amorphous silicon, cadmium telluride, copper indium selenide, copper indium gallium selenide, perovskite, gallium arsenide, indium phosphide, copper zinc tin selenide, quantum dot semiconductors, organic solar cells or can be dye-sensitized solar cells. Preferred are monocrystalline or polycrystalline silicon solar cells. It is also possible that the solar cells comprise an anti-reflective coating on the active sides of the solar cells, for example magnesium fluoride, silicon oxide, titanium oxide, aluminum oxide or silicon nitride. The solar cell layer (c) has a refractive index in the range of from 1.80 to 5.00 , preferably 1.90 to 2.50 and more preferably 2.00 to 2.20, which is for example measured by ellipsometry. In case that the solar cell layer (c) comprises multiple layers, the refractive index is considered to be the refractive index of the outer layer which is directly in contact with the additional layer R. Preferably, the solar cell layer (c) comprises or consists of bifacial solar cells and an anti-reflective coating on the active sides of the solar cells comprising silicon nitride.

Between the lower surface of the solar cell layer (c) and the backsheet (e), a second encapsulant adhesive layer (d) is present, which preferably comprises ethylene-vinyl acetate. The thickness of the second encapsulant adhesive layer (b) can be up to 3 mm, preferably in the range of from 20 to 200 µm. The second encapsulant adhesive layer (d) has preferably a refractive index in the range of from 1.40 to 1.60, preferably 1.45 to 1.55, more preferably 1.47 to 1.55. In a more preferred embodiment, the second encapsulant adhesive layer (d) is the same as the first encapsulant adhesive layer (b).

According to the invention, an additional layer R, preferably comprising silica nanoparticles, is present between the solar cell layer (c) and the second encapsulant adhesive layer (d). The refractive index of the additional layer R is in the range of from 1.15 to 1.50, preferably 1.20 to 1.45, more preferably from 1.20 to 1.44. The refractive index of the layer is preferably uniform over the complete layer. The refractive index can be measured for example by ellipsometry. The thickness of the layer is in the range of from 250 nm to 10000 nm, preferably in the range of from 500 nm to 5000 nm, more preferably 1000 nm to 2000 nm and can be determined for example by cross-section SEM. The silica nanoparticles are preferably made from core-shell nanoparticles, hollow nanoparticles or a mixture thereof, more preferably hollow nanoparticles. The silica nanoparticles are preferably obtained by a micelle template-based or latex template-based process. Examples of the micelle template-based process are disclosed in WO 2008/028641 A2 or WO 2015/075229 A1 and for the latex template-based process in WO 2009/03073 A2.

The coating composition to obtain the additional layer R can further comprise a binder, preferably a polymer binder or an inorganic binder.

Suitable organic binders include a range of different polymers and thermally or radiation - e.g. UV - curable monomers, as known to the skilled person. Organic binders, especially radiation curable binders generally have the advantage that they can be cured at relatively low temperatures of preferably below 250°C, compatible with e.g. thermoplastic substrates. Examples of suitable organic binders that may be applied include radical curable - peroxide-or photo-initiated - compositions comprising vinyl monomers and vinyl polymers having unsaturated groups, like acrylates, methacrylates, maleate/vinyl ethers, etc., or radical curable unsaturated polyesters or polyurethanes in styrene and/or (meth)acrylates.

Suitable inorganic binders include inorganic oxide precursors like metal alkoxides, metal chelates, metal salts, and mixtures thereof. Suitable metals include at least one element selected from Si, Al, Be, Bi, B, Fe, Mg, Na, K, In, Ge, Hf, La and lanthanoids, Sb, Sn, Ti, Ta, Nb, Y, Zn and Zr; preferably the metal is at least one element selected from Si, Al, Ti, and Zr. Suitable inorganic oxide precursors include those compounds that can react via hydrolysis and/or condensation reactions to form the corresponding oxide, as is well known in the art. The inorganic oxide precursor (which in the context of the present invention is considered polymerizable through for example condensation, or polymerized in a glass, sol-gel or crystal stage) can be a metal salt or an organo-metallic compound, like an alkoxy, an aryloxy, a halogenide, a nitrate, or a sulphate compound, and combinations thereof. Preferred precursors include alkoxy silanes, including halogenated - especially fluorinated - derivates, like tetramethoxy silane (TMOS), tetraethoxy silane (TEOS), methyltrimethoxy silane, methyltriethoxy silane, fluoroalkoxy silanes like trifluoropropyl trimethoxy silane, titanium tetraisopropoxide, aluminium nitrate, aluminium butoxide, yttrium nitrate and zirconium butoxide. More preferably, the precursor comprises TMOS and/or TEOS.

The inorganic oxide precursor can be a mixture of inorganic oxide precursor compound and corresponding inorganic oxide. Such mixture may for example result in case a precursor compound partially pre-reacts or pre-hydrolyses in aqueous medium during making the composition to form oligomeric species, typically in the form of nano-sized particles, which is a well-known procedure in sol-gel technology.

It is also possible to add a combination of inorganic and organic binders, to for example further improve properties of the resulting coating or enhance adhesion to the substrate. These binders may form polymers or networks on their own but can also co-react.

In a preferred embodiment, the binder used in the process according to the invention consists of at least one inorganic oxide precursor.

The coating composition comprising silica nanoparticles can further comprise at least one auxiliary component. Preferably, auxiliary components are added in an amount of less than 20 wt.-% based on the sum of silica nanoparticles and binder, more preferably less than 10 or 5 wt.-%. These components may be added to assist in processing of the coating composition or to affect other functionalities of the coating to be made from the composition. Examples of auxiliary components include acids, bases, buffer agents, catalysts, coupling agents, surfactants, anti-foaming agents, chelating agents, slip agents, thickening agents, and levelling agents.

The solids content of the coating composition comprising silica nanoparticles can be adjusted by removing or adding water and/or organic solvent. Preferably, the solids content is between 5 and 30 wt.-%, more preferably 10 to 30 wt.-%. If the solids content is lower than 5 wt.-%, it is suitable to apply multiple layers of coating.

Typically, the viscosity of the coating composition is at least about 0.6 mPa.s, preferably at least 1.0 or 2.0 mPa.s. Depending on the deposition technology applied, the viscosity may be as high as 1000 mPa.s. Preferably viscosity is at most 500, 300 or 200 mPa.s. for making thin layers of homogeneous thickness. The viscosity can be measured with known methods, for example with an Ubbelohde PSL ASTM IP no 1 (type 27042) especially for low viscosity ranges, or with a Brookfield viscometer. The values for viscosity in the application are for a temperature of 25°C. Solids content may be adjusted by removing solvent by e.g. evaporation or by adding solvent.

The additional layer R can be applied directly to the solar cell layer (c) by a coating composition, preferably comprising silica nanoparticles. It is also possible to apply more than one layer, preferably with intermediate drying performed after the application of each layer. In some embodiments, intermediate drying and curing is performed after applying some or all of the layers.

The additional layer R can be applied to the solar cell layer (c) with various deposition techniques, as known to a skilled person for making thin homogeneous layers. Suitable methods include spin-coating, dip-coating, spray-coating, roll-coating, slot die-coating, screenprinting, aerosol coating and the like. Preferred methods are dip-coating, spray coating, spin-coating and slot die-coating, most preferred is spray coating. The thickness of the additional layer R to be applied depends on the amount of solid film forming components in the composition, and on the desired layer thickness after subsequent drying and curing. The skilled person will be able to select appropriate methods and conditions depending on the situation.

The coating composition is preferably applied to the solar cell layer (c) for making a single layer, preferably comprising silica nanoparticles, more preferably hollow nanoparticles, in such wet thickness that will result in a thickness after drying and/or curing of 250 nm to 10000 nm, preferably 500 nm to 5000. In case of multiple layers, the skilled person may select different layer thicknesses.

The step of drying and optionally curing the applied coating composition will comprise drying to evaporate at least part of the solvent and other volatile components, and optionally curing to complete reaction of a binder into for example inorganic oxide(s) and removing residual volatiles and optionally non-volatile organic components; depending on curing temperature.

Drying preferably takes place under ambient conditions (e.g., 15-30°C), although elevated temperatures (e.g., up to about 250°C, more preferably up to 100, 50 or 40°C) may also be used to shorten the total drying time. Drying may be promoted by applying an inert gas flow or reducing pressure. Specific drying conditions may be determined by a person skilled in the art based on components to be evaporated. It is also suitable to use infrared light.

In one embodiment of the invention, the applied additional layer R is cured after drying, i.e., after substantially removing volatiles. Curing may be performed using a number of techniques including thermal curing, flash heating, UV curing, electron beam curing, laser-induced curing, gamma radiation curing, plasma curing, microwave curing or combinations thereof. Curing conditions are depending on the coating composition and curing mechanism of the binder, and on the type of substrate. The skilled person is able to select proper techniques and conditions. Thermally curing coatings at e.g., temperatures above 250°C is preferred for inorganic oxide precursors as binder to result in e.g., better mechanical properties. Such conditions are often not possible for curing a plastic substrate in an oven; and also not needed to generate the desired properties with the coating composition of the invention. If high temperature curing is desired, a surface heating technique like flash heating may advantageously be applied to minimise exposure of the substrate to high temperature. It is also suitable to add an acrylic binder system for curing.

In case of an inorganic substrate curing can be performed at relatively high temperatures of up to the melting point of the silicon solar cell. Such heating above the decomposition temperature of organic compound or polymer will remove such compounds to result in porosity, and also promote formation of oxides from inorganic oxide precursors, especially when in the presence of oxygen; resulting in both curing and removing organics by calcination. Such curing by heating is preferably performed in the presence of air. If desired, the air may comprise increased amounts of water (steam) to further enhance curing and formation of an inorganic oxide coating. The product obtained by such process is typically a fully inorganic porous coating.

The backsheet (e) of the solar module has to provide protection for the solar module from the environment and comprises polymers like polypropylene, polyethylene, polyvinyl chloride, polyesters like polyethylene terephthalate, fluoro-resins like PTFE or acrylic resins. The backsheet (e) can also comprise additives like UV stabilizers, inorganic fillers or pigments. The backsheet preferably comprises black pigments.

The solar module also often comprises (f) a frame to increase stability of the solar module and (g) a junction box.

In a preferred embodiment, the solar cell layer (c) has a refractive index at the outer layer in the range of from 1.80 to 2.50 and the additional layer R has a refractive index in the range of from 1.15 to 1.45. In another embodiment, the solar cell layer (c) has a refractive index at the outer layer in the range of from 1.90 to 2.40 and the additional layer R has a refractive index in the range of from 1.20 to 1.44.

### Experiments

For the experiments single-cell mini modules were prepared comprising a glass front sheet, commercial bifacial solar cells with a dimension of 15 cm x 15 cm (length x width), having a refractive index of 1.8 at the outer layer, EVA as first and second encapsulant and a black backsheet. One half of the single-cell mini modules was coated at the backside of the solar cell with an additional layer R having a refractive index of 1.3 and comprising silica nanoparticles. The short circuit current was measured at an illumination with a light source which emitted wavelengths of 1100 to 1270 nm at an angle of 90° and was compared to the short circuit current of the uncoated half of the same mini module (prevention of cell-to-cell-variation, 12 measurements for each cell). The area which was illuminated was about 2 cm². The uncoated half of the mini module was set as reference to a normalized short circuit current of 100% (example 1). The results are shown in table 1 wherein example 2 is the average measured short circuit current of five different mini modules.

For measuring the short circuit current at an angle of 55°, the backside of the solar cell in the mini module was coated with an additional layer R having a refractive index of 1.3 and comprising silica nanoparticles (example 3) and with white paint (example 4). For example 5, the black backsheet was exchanged with a white paper. The short circuit current of the mini modules was measured at an angle of 90° and compared to the measurement of the same mini modules at an angle of 55°.

### Coating application

The applied coating was based on an emulsified solvent with a silica shell and a particle size <100 nm and silica binder in an alcoholic solution (Covestro - MP Coat ARCA R11). The coating was applied in examples 2 and 3 on half of the back of the cell via consecutive spray coating applications until a dry coating film thickness of 1000-1200 nm was obtained (determined via cross section SEM analysis). A card board mask was used to prevent that coating liquid would reach the uncoated side of the cells. After application, the coating was dried for 1h at a temperature of 80°C to allow evaporation of the solvent and yield a low refractive index silica coating with a refractive index in the solar spectrum of 1.3.

**Table 1: Short circuit current at an angle of 90° compared to uncoated mini module**

| Example | Normalized short circuit current [%] | Difference to reference |
|---|---|---|
| 1* | 100 | - |
| 2 | 102.3 | 2.3 |

| | | |
|---|---|---|
| * Reference or comparative example | | |

Table 1 shows that if a coating with a low refractive index comprising silica nanoparticles is added between the second encapsulant adhesive layer and the outer layer of the solar cell (example 2), the short circuit current is increased compared to a mini module without any coating (example 1). Table 2 shows that for an inventive mini module (example 3) the short circuit current of converting light which enters the solar module from an angle of 55° is even more increased.

**Table 2: Short circuit current difference at an angle of 55°**

| Example | short circuit current increase in % |
|---|---|
| 3 | 6.0 |
| 4* | 0.7 |
| 5* | -7.8 |

| | |
|---|---|
| * Reference or comparative example | |

## Claims

1. A solar module comprising
(a) a glass front sheet at the top of the solar module,
(b) a first encapsulant adhesive layer, preferably having a refractive index in the range of from 1.40 to 1.60,
(c) a solar cell layer, comprising a bifacial solar cell and having optionally multiple layers, having a refractive index in the range of from 1.80 to 5.00,
(d) a second encapsulant adhesive layer, preferably having a refractive index in the range of from 1.40 to 1.60,
(e) a backsheet at the bottom of the solar module,
wherein between the solar cell layer (c) and the second encapsulant adhesive layer (d) an additional layer R with a refractive index in the range of from 1.15 to 1.50 and a thickness of 250 to 10000 nm is present.

2. A solar module as claimed in claim 1, wherein the additional layer R comprises silica nanoparticles.

3. A solar module as claimed in claim 2, wherein the silica nanoparticles are core-shell nanoparticles and/or hollow nanoparticles.

4. A solar module as claimed in any of claims 1 to 3, wherein the additional layer R has a thickness in the range of from 500 nm to 5000 nm.

5. A solar module as claimed in any of claims 1 to 4, wherein the first encapsulant adhesive layer (b) and the second encapsulant adhesive layer (d) have a thickness in the range of from 20 to 200 µm.

6. A solar module as claimed in any of claims 1 to 5, wherein the refractive index of the additional layer R is in the range of from 1.20 to 1.45.

7. A solar module as claimed in any of claims 1 to 5, wherein the refractive index of the additional layer R is in the range of from 1.20 to 1.44.

8. A solar module as claimed in any of claims 1 to 7, wherein the solar cell layer (c) has a refractive index in the range of from 1.90 to 2.40 at the outer layer.

9. A solar module as claimed in any of claims 1 to 8, wherein the backsheet (e) comprises black pigments.

10. A solar module as claimed in any of claims 1 to 9, wherein the solar cell layer (c) comprises a bifacial solar cell with at least one surface which is coated with a composition comprising silicon nitride.

11. A solar module as claimed in any of claims 1 to 10, wherein the solar cell layer (c) consists of bifacial solar cells with active sides and an anti-reflective coating on the active sides of the bifacial solar cells comprising magnesium fluoride, silicon oxide, titanium oxide, aluminum oxide or silicon nitride.

12. A solar module as claimed in any of claims 1 to 11, wherein between the additional layer R and the backsheet (e) a layer comprising ethylene-vinyl acetate is present.

13. A process for preparing a solar module as claimed in any of claims 1 to 12.

14. A process as claimed in claim 13, wherein the additional layer R is obtained by a coating composition comprising silica nanoparticles.

15. A process as claimed in claim 14, wherein the silica nanoparticles are core-shell nanoparticles and/or hollow nanoparticles.
